# EUROPEAN PATENT APPLICATION

(11) **EP 2 527 121 A1**
(43) Date of publication of application: **28.11.2012**
(21) Application number: 12169138.0
(22) Date of filing: 23.05.2012
(51) Int. Cl.: B28D 5/00, H01L 21/67

(54) **Device for splitting substrat with obstacle detection means**

(30) Priority: 24.05.2011 FR 1154510
(71) Applicant: Soitec, 38190 Bernin (FR)
(72) Inventor: Besnard, Teddy, 38120 SAINT-EGREVE (FR)
(74) Representative: Collin, Jérôme

(57) **Abstract**

The invention relates to a device (1) for splitting a substrate (2), said substrate comprising two adjoining wafers defining between them a cleavage plane, said device comprising
- a base (11),
- means (12) for splitting substrate wafers,
- means for performing controlled displacement of some substrate wafers (2) comprising at least one pusher (5) mobile relative to the base (11) of the device (1) comprising handling means for substrates, said handling means being adapted to accommodate substrates in a reception space of substrates (2) on the pusher (5),

said pusher (5) being capable of displacing substrates (2) arranged in a support (8), the device comprising detection means (9) adapted to determine the absence or the presence of obstacles inside at least one region of the reception space of the pusher (5) when the pusher (5) is in a detection position, said region being located near the handling means for substrates.

## Description

### GENERAL TECHNICAL FIELD

The present invention generally relates to the treatment of materials, and more particularly substrates for electronics, optics or optoelectronics.

More precisely, the invention relates to a device for splitting two wafers of material initially adjoining one another, according to a splitting plane.

### PRIOR ART

It is specified that adjoining wafers mean wafers positioned so as to be in physical contact.

And adjoining wafers can accordingly:
- be further connected by structural elements (this is the case especially for wafers defining between them an embrittlement plane such as mentioned hereinbelow, and which have undergone treatment - thermal for example - for completing only partial cleavage of the two wafers on either side of the embrittlement plane),
- or on the contrary not be connected by any structural element, but made solid only by means of forces such as those corresponding to a suction effect between the adjoining but disjointed surfaces of the two wafers, and/or Van der Waals forces (this is the case especially for wafers initially originating from the same substrate, between which an embrittlement plane has been defined, and which have undergone thermal treatment or other to carry out complete cleavage between the two wafers on either side of the embrittlement plane).

The two adjoining wafers form an assembly are called a substrate.

Thus, such a device is used for the splitting of wafers of a structure of SOI type (acronym corresponding to the English term of Silicon On Insulator), but also of type SOA (acronym corresponding to Silicon On Anything), or even of type AOA (acronym corresponding to Anything On Anything).

It is specified however that a particularly advantageous application of the device according to the invention, which will be described hereinbelow by way of non-limiting example, relates to the splitting of wafers of a structure of SOI type.

A manufacturing process for substrates of SOI type which is known by the generic name of SMARTCUT^{™} process comprises the following main steps:
○ A step for implantation of species (ions or atoms) at a given depth of a substrate of semiconductor material such as monocrystalline silicon, so as to define an embrittlement plane in the substrate,
○ A step for fixing this substrate on a stiffener such as for example silicon optionally oxidised at the surface, then
○ A cleavage step intended to at least partially ensure fracture according to the embrittlement plane defined at the level of the layer of implanted species
○ A wafer is located on each side of the fracture (a first wafer corresponding to the part of the substrate of monocrystalline silicon which has been detached and optionally fixed on the stiffener, to constitute the SOI, and a second wafer which corresponds to the silicon residue).

In this type of process, whether the fracture which occurs during the cleavage step is complete or partial, the two wafers in practice remain adhered to one another (by simple suction effect in the case where the fracture was complete, the faces of the wafers being extremely smooth).

It therefore remains necessary in all cases to finalise their splitting to obtain both the final SOI substrate, and also the residue of the monocrystalline silicon, which could be recycled in the process.

There are substrate-splitting devices such as the device described in the European patent published under number EP 1 423 244.
Such a device comprises
- a base,
- splitter means of substrate wafers,
- means for performing controlled displacement of some substrate wafers
comprising at least one pusher mobile relative to the base of the device, said pusher being capable of displacing substrates arranged in a support, the direction of storage of said substrates defining a longitudinal direction for the device.

However, the splitting device described in European patent EP 1 423 244 does not give total satisfaction with respect to the lack of reliability of the device which can cause loss substrates and prolonged stoppages of said device.

The invention aims to rectify these disadvantages.

The present invention aims especially to increase the reliability of the substrate-splitting device.

Another aim of the present invention is to generally improve the splitting process of substrate wafers.

### PRESENTATION OF THE INVENTION

In order to achieve the abovementioned aims, according to a first aspect the present invention relates to a substrate-splitting device, said substrate comprising two adjoining wafers defining between them a cleavage plane, said device comprising
- a base,
- splitter means of substrate wafers,
- means for performing controlled displacement of some substrate wafers comprising at least one pusher mobile relative to the base of the device comprising handling means for substrates, said handling means being adapted to accommodate substrates in a reception space of substrates on the pusher,
said pusher being capable of displacing substrates arranged in a support, the direction of storage of said substrates defining a longitudinal direction, the device comprising detection means adapted to determine the absence or the presence of obstacles inside at least one region of the reception space of the pusher when the pusher is in a detection position, said region being located near the handling means for substrates

According to other advantageous and non-limiting characteristics:
- the detection means are solid with the base;
- the detection means comprise at least one transmitter for sending a beam of electromagnetic waves and a receiver associated with said transmitter for receiving said beam of electromagnetic waves, the trajectory of the beam of electromagnetic waves between the transmitter and the receiver defining a region of the reception space inside which the absence or the presence of obstacles is determined when the pusher is in a detection position;

- a transmitter and a receiver associated with said transmitter are placed according to the longitudinal direction;
- the reception space for substrates is located between the transmitter and the receiver when the pusher is in a detection position;
- the substrate-handling means present a profile section in a section perpendicular to the longitudinal direction of the pusher comprising several zones characterised by a distinct profile zone in the section perpendicular to the longitudinal axis of the pusher, the detection means being placed so as to define a region of the reception space for substrates associated with each one of the zones, the absence or the presence of obstacles being determined for each one of the regions of the reception space for substrates associated with each one of the zones;
- the detection position of the pusher is located between a retracted position of the pusher in the base and a position in which the pusher supports the substrates.

According to a second aspect the invention relates to a control process of the device according to any one of the preceding claims, in which the pusher is immobilised in its detection position until determination by the detection means of the absence of obstacles inside said regions of the reception space.

Each time the pusher reaches its detection position, the latter is preferably immobilised until determination by the detection means of the absence of obstacles inside said regions of the reception space.

Furthermore, the determination of the presence of obstacles inside said regions of the reception space by the detection means causes the stoppage of displacements of elements of the device.

### PRESENTATION OF FIGURES

Other characteristics and advantages of the present invention will emerge from the following description of a preferred embodiment. This description will be given in reference to the attached diagrams, in which:
- Figure 1 is a schematic frontal view of an assembly of a substrate-splitting device according to the invention,
- Figure 2 is a three-quarter view of a substrate-splitting device,
- Figure 3 is a sectional view perpendicular to the longitudinal axis of a pusher,
- Figure 4 illustrates the arrangement of detection means placed on a structure,
- Figure 5 illustrates the arrangement of detection means placed on a structure, with a representation of electromagnetic beams,
- Figure 6 illustrates the arrangement of detection means with the pusher in a detection position.

### DETAILED DESCRIPTION

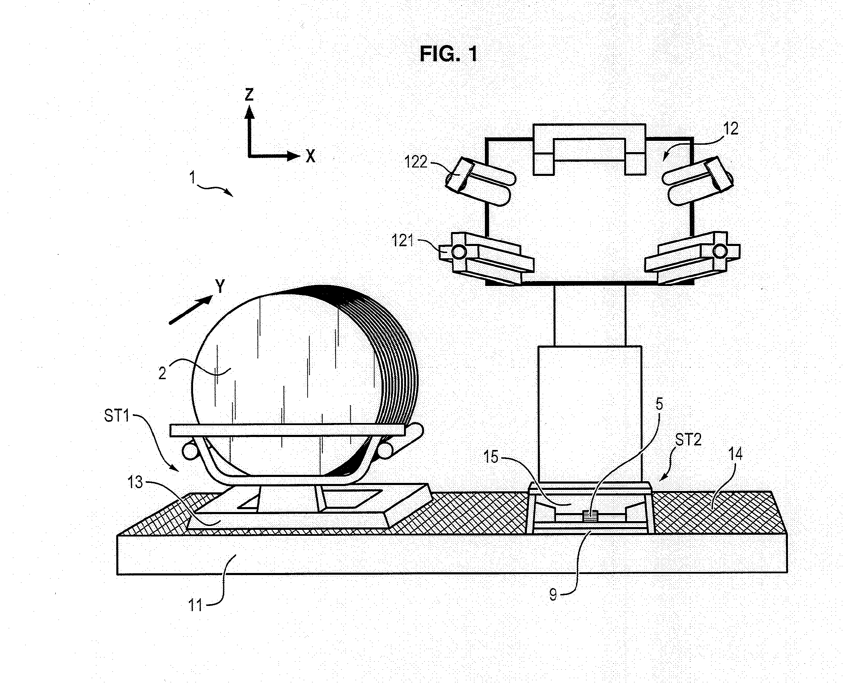

As explained above, a substrate-splitting device is used for splitting substrates, said substrates comprising two adjoining wafers defining between them a cleavage plane. Figure 1 illustrates such a device 1.

These substrates 2 are arranged on a support 8. The direction of storage on said support 8 of said substrates 2 defines a longitudinal direction Y for the device 1. This support 8 is adapted for the handling of silicon substrates. This support 8 can for example be a quartz nacelle. The support 8 is used for the handling of substrates 2, especially for guiding them to a treatment device (not shown) - for example thermal - within the scope of the splitting process of said substrates, to perform cleavage, total or partial, of an embrittlement plane defined between the wafers constituting said substrates.

Other complementary handling means (not shown) of substrates or of wafers resulting from the splitting of said substrates, are also provided, especially to feed the splitting device with substrates, and to evacuate the wafers.

These handling means can be for example of FOUP type (Front Opening Unified Pod) or of FOSB type (Front Opening Shipping Box).

In this illustration, the first workstation ST1 of a substrate-splitting device 1 is designed to house a support 8 which can contain a plurality of substrates 2. A typical capacity of the support 8 is for example 25 to 50 substrates (Figure 1 shows fewer for the sake of clarity).

The substrates have a diameter of a few hundreds of millimetres, typically 300 mm.

The substrates 2 are aligned in the support 8 according to a substrate-storage direction Y so that the faces of said substrates 2 are perpendicular to the direction of storage Y.

Here, too, the rear face of a substrate is the face opposite to the active face, on which specific treatments (constitution of optical, electronic structures...) are to be made.

Housings uniformly distributed according to the direction of storage of the substrates are provided to this effect in the support 8, so that the substrates 2 are distributed uniformly according to a given reference pitch.

The support 8 can be displaced by means of a mobile trolley 13 moving in the longitudinal direction Y to bring in and withdraw the support 8 of the first workstation ST1.

The support 8 can originate directly from an oven in which the substrates 2 have undergone thermal treatment in light of causing or preparing the cleavage of each substrate into two wafers (typically a SOI or SOA wafer, and a silicon residue wafer).

As indicated above, the cleavage of these substrates 2 into two wafers must be finalised (that is, the two wafers must now split from one another).

An assembly 12 of splitter means is represented at the level of the second workstation ST2, comprising apart from splitter means such as a separator, handling means for substrates, for example combs 121, 122.

A pusher 5, which is retracted in Figure 1 in the base 11 at the level of the opening 15 of the second station ST2, is adapted to move laterally (according to the direction X) from one station to another, and more precisely from the opening 15 of one station to the opening 15 of the other station, at the same time as the splitter means assembly 12.

At the level of the first station ST1, the pusher 5 can be deployed upwards (according to the direction Z) to engage in openings left free between the structural elements bearing the housings in the lower part of the support 8, and can lift the substrates of the support 8. The pusher 5 can also be deployed upwards (according to the direction Z) to engage in openings left free between the structural elements of a carrier (not shown), for the second station ST2.

The assembly 12 of substrate-splitter means is mounted for example on rails which run parallel to the direction X, with control means of the displacement of this assembly 12 being provided. Also, the splitter means assembly 12 comprises substrate-handling means or wafers in the form of combs 121, 122.

Thus, the assembly 12 of splitting means can be used for the handling of substrates or wafers, especially for the displacement of the latter from the support 8 to additional handling means (not shown) of FOUP type or of FOSB type by means of a carrier and an articulated arm.

Thus, in the case of the use of FOUP, said FOUP containing a plurality of substrates in a horizontal position is brought near an articulated robotic arm of SCARA type (acronym for selective compliance assembly robot arm). Said articulated robot moves the substrates from the FOUP to a tiltable carrier (not shown). The carrier tilts, with the substrates being in a vertical position, that is resting on their respective edge.

The combs 121, 122 of the assembly 12 are used to handle the substrates. The pusher 5 lifts the substrates to bring them to the level of the combs 121, 122. The combs 121, 122 then hold the substrates and the assembly 12 is displaced laterally according to the direction X to be positioned at the level of the support 8 on the first workstation ST1.

The pusher 5, which accompanies the displacement of the assembly of the splitter means 12, is now also positioned at the level of the first station ST1. The pusher 5 is lifted up in the direction Z across of the support 8 and comes into contact with the substrates 2 to support them, while the combs 121, 122 of the assembly 12 release said substrates 2. The pusher 5 supporting the substrates 2 now redescends and in its movement deposits the substrates 2 on the support 8.

A similar handling process is carried out in the reverse direction during splitting of the substrates 2, after treatment to produce at least partial cleavage between the wafers.

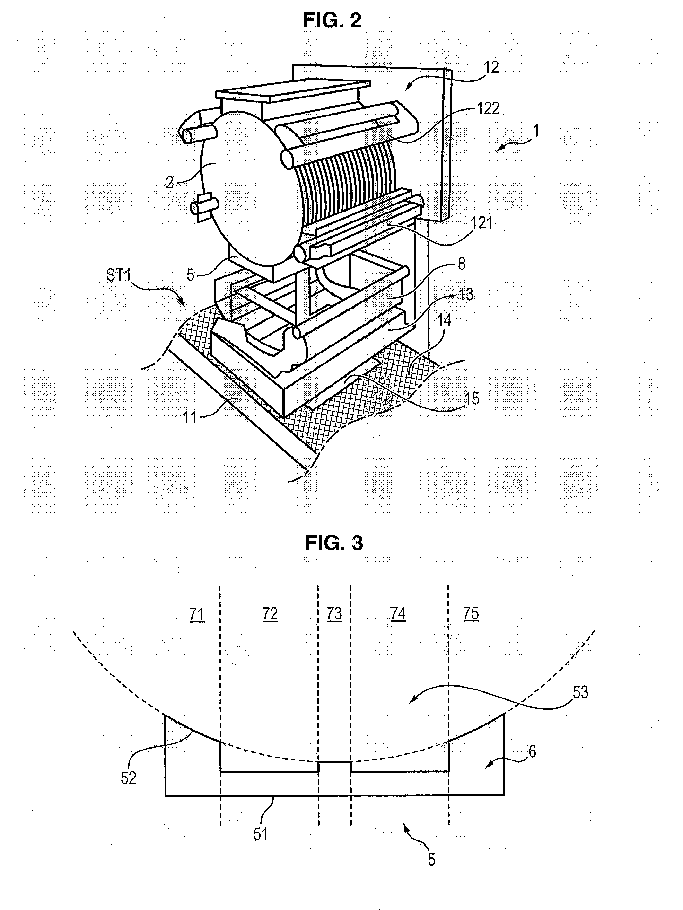

Figure 2 illustrates the splitting device 1 when the pusher 5 is in a high position in which it supports the substrates 2 to bring them into contact with the combs 121, 122 of the assembly 12. The pusher 5 can traverse the support 8 upwards to gather the substrates 2 contained therein.

In this regard, the pusher 5 is fitted with substrate-handling means comprising housings which extend uniformly spaced, according to the storage direction Y of substrates 2 to house the substrates in these housings. The storage direction Y of substrates 2 is a longitudinal direction for the pusher 5.

The handling means of the pusher 5 are for example made of polymer material such as polyetheretherketone.

The housings are preferably of two types, single and double. The housings of double type are designed to receive and hold substrates constituted by two adjoining wafers, while the housings of single type are designed to receive and hold wafers originating from substrate splitting.

As illustrated in Figure 3, the substrate-handling means present a section profile 6 in a section perpendicular to the longitudinal axis Y of the pusher 5. This section profile 6 comprises several zones 7 characterised by a distinct profile zone in the section perpendicular to the longitudinal axis of the pusher Y.

The external zones 71, 75 are distinguished by a profile projecting and inclining inwards relative to the base 51 of the pusher on which the substrate-handling means are positioned.

The intermediate zones 72, 74 are distinguished by a profile parallel to the base 51 of the pusher.

The central zone 73 is distinguished by a projecting profile, at a height less than the profiles of the external zones 71, 75 and parallel to the base 51 of the pusher.

Such a profile section 6 of the pusher allows the latter to keep the substrates in a substrate-reception space 2 on the pusher 5. This reception space extends in the space located above the substrate-handling face comprising the upper face of the zones 7, on the opposite side of the base 51 of the pusher.

The position of each substrate 2 or wafer relative to the pusher 5 is automatically adjusted by cooperation of forms, the housings of the pusher 5 also being sufficiently adjusted to keep the substrates or the wafers in a vertical position.

At the level of the first station ST1, the pusher 5 can also redescend with substrates or wafers, and deposit these substrates or wafers in the support 8, as it passes downwards through the openings of the structural elements of the support 8, the support 8 intercepting the substrates or wafers by arranging them in housings, while the pusher 5 continues its course downwards until it is retracted in the base 11. The same applies at the level of the second station ST2 with the carrier or any other substrate-handling means.

Starting from a situation in which:
- the support 8 contains substrates 2 which have undergone cleavage (said cleavage having to be done mechanically, or not - in any case, according to the invention the two wafers will be split from each substrate) and is in the station ST1,
- the assembly 12 of splitter means and the pusher 5 are opposite and vertical to the station ST1 (following displacement adapted according to the direction X of the Figure 1), and
- the splitter means 12 comprise symmetrical combs which are spread and opened; the ascension of the pusher 5 is the first to be controlled.

The pusher 5 gathers the substrates 2, each substrate 2 being received by a housing of the pusher 5 (located under the substrate for this purpose, the housings having also V-shaped slopes for forming a funnel and collecting a substrate).

The pusher in position at the level of the station ST1 raises the substrates to a high position, in which the centre of the substrates is at the height of the combs 121, 122 of the assembly 12, in the position illustrated in Figure 2.

The combs 121, 122 then engage in the substrates 2. The substrate-splitter means split the substrates. These splitter means comprise at least one separator, for example in the form of a blade engaging in the cleavage plane between the adjoining wafers. This separator is tightened on each substrate to carry out the splitting of the two wafers of each substrate and their separation, as explained in detail in patent EP 1 423 244. The pusher 5 holds the lower part of the substrates 2 during the splitting of the wafers.

Once the splitting is completed, the pusher 5 is taken back down empty and is retracted in the base 11, so that the wafers coming from the splitting of the substrates 2 are held just by the combs 121, 122 of the assembly 12.

The assembly 12 of the splitter means is then displaced according to the direction X of Figure 1 by its control means, until it is vertical to the station ST2. The pusher 5 is solidary with the assembly 12 of splitter means and moves laterally according to the direction X until it reaches the second station ST2 at the same time as the assembly 12 of splitter means. The displacement of the pusher 5 is done in the retracted position, the pusher 5 then passing under plaques 14 forming the upper part of the base 11.

Means for handling wafers are placed at the level of the station ST2. These handling means are adapted to accommodate and hold wafers or substrates and the pusher 5 is capable of passing through structural elements of said handling means. In reference to the above example, this can be the tiltable carrier (not shown).

The ascension of the pusher 5 is then controlled so that the latter comes into contact with the lower edge of the wafers by passing through the handling means. In this position, the pusher 5 supports the wafers. The combs 121, 122 of the assembly 12 then release the wafers so that the wafers are held by the pusher 5 only.

The pusher 5 and the wafers which it supports are then brought down. The pusher 5 passes downwards through the openings of the structural elements, the support 8, said support 8 intercepting the wafers by arranging them in housings, while the pusher 5 continues its course down until it is retracted in the base 11.

The combs 121, 122 can be adapted to release the wafers in several steps, for example just the wafers comprising the active faces of the substrates in a first step, then the other wafers, or vice versa. In this case, the same handling using the adapted handling means and the pusher 5 is carried out for each one of the steps.

The applicant discovered during researches aimed to optimise the yield of the splitting process of substrate wafers that a significant reliability problem resulted from the breaking of substrate wafers. In fact, since the substrate wafers are subjected to varied mechanical and thermal stresses, the latter can break and damage the device.

In the case of breakage of a substrate wafer before, during or after splitting, debris of various sizes then occur in the operating perimeter of the machine.

These debris can be found on the pusher, more precisely on the handling face of substrates of the pusher. It can then happen that these debris prevent proper receipt of the substrates by the pusher in the substrate-reception space, which translates into misplaced substrates which cannot be split or which break in turn.

Also, the presence of these debris on the pusher can damage the base 11. In fact, the pusher can have to move laterally from one workstation to another. During these displacements, it moves into a retracted position in the base 11, and moves laterally under plates 14 forming support for the support 8, to be positioned in the opening of another workstation to support the substrates or the wafers.

Any possible debris present in the reception space can protrude into the reception space of the pusher and encounter part of the base 11 or structural elements, such as the support 8, during lateral displacement of the pusher from one workstation to another. This encounter can result in alteration of the handling face of the pusher 5, damage to the base 11 or structural elements, or even in deterioration of the displacement or control system of the pusher 5 resulting from the resistance opposed by said debris to displacement of the pusher 5.

The device 1 according to the invention has detection means 9 adapted to determine the absence or the presence of obstacles inside at least one region of the reception space of the pusher 5 when the pusher 5 is in a detection position, said region being located near the handling means for substrates. These detection means are solid with the base 11 and are placed at the level of at least one workstation ST1, ST2, preferably the first station ST1, even though they can be placed at the level of each of the stations ST1, ST2.

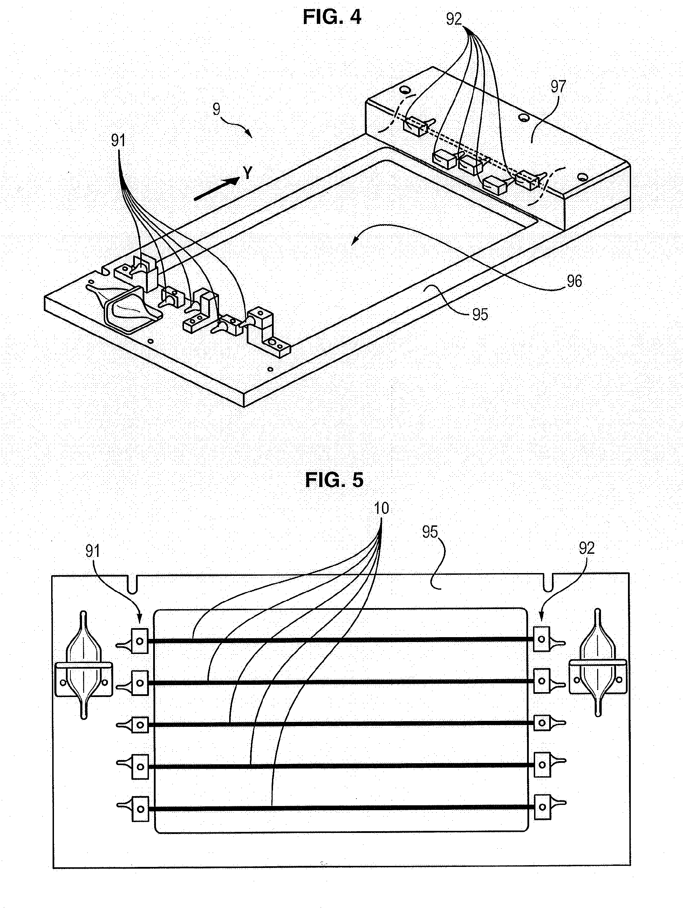

Figures 4 and 5 illustrate a non-limiting example of detection means which can be used within the scope of the invention. The detection means 9 comprise at least one transmitter 91 for sending an electromagnetic wave beam 10 and a receiver 92 associated with said transmitter 91 for receiving said electromagnetic wave beam 10, the trajectory of the electromagnetic wave beam 10 between the transmitter 91 and the receiver 92 defining a region of the reception space inside which the absence or the presence of obstacles is determined when the pusher 5 is in a detection position.

For example, a transmitter 91 can send an electromagnetic wave beam 10 of laser beam type which is received by the receiver 92 to which it is associated, thus determining the absence of obstacles in the reception region defined by the trajectory of the laser beam. The presence of an obstacle, such as substrate debris, in this detection region, would prevent receipt of the laser beam by the receiver 92. Non-receipt of the laser beam by the receiver 92 determines the presence of obstacles in said region of the reception space.

A transmitter 91 and a receiver 92 associated with said transmitter 91 can be placed according to the longitudinal direction Y of the pusher, on either side of an opening 96 through which the pusher passes. These detection means 9 can be placed on a structure 95 which is fixed on the base 11 of the device 1, making the detection means solid with said base. The detection means 9 can also be covered by a hood 97 for protection.

The detection position of the pusher 5 is located between a retracted position of the pusher 5 in the base 11 and a high position in which the pusher 5 supports the substrates 2. The position of the pusher 5 when the latter is located between the detection means 9 defines a detection position of said pusher 5. A single one of the workstations can be fitted with detection means 9, preferably the first station ST1 where splitting takes place and where the substrates or wafers are the most likely to break. There is preferably a detection position for each of the workstations ST1, ST2, each of these being fitted with detection means 9.

More precisely, the pusher 5 is in a detection position when the beams 10 of electromagnetic waves pass through a region of the reception space of the pusher 5, said region being located near the substrate-handling means 52. The detection region must preferably be sufficiently close to the substrate-handling means 52 so that debris of a sufficient size to alter the handling of the substrates or the displacement of the pusher 5 and which would rest on the handling means 52 of the pusher 5, is at least in part in the detection region.

The detection means 9 are preferably activated only when the pusher 5 is in a detection position.

As explained earlier and illustrated in Figure 3, the substrate-handling means 52 present a profile section 6 in a section perpendicular to the longitudinal direction Y of the pusher comprising several zones 7 characterised by a distinct profile zone in the section perpendicular to the longitudinal axis Y of the pusher 5, the detection means 9 being placed so as to define a region of the reception space 53 of the substrates 2 associated with each of the zones 7, the absence or the presence of obstacles being determined for each of the regions of the reception space 53 of the substrates 2 associated with each of the zones 7.

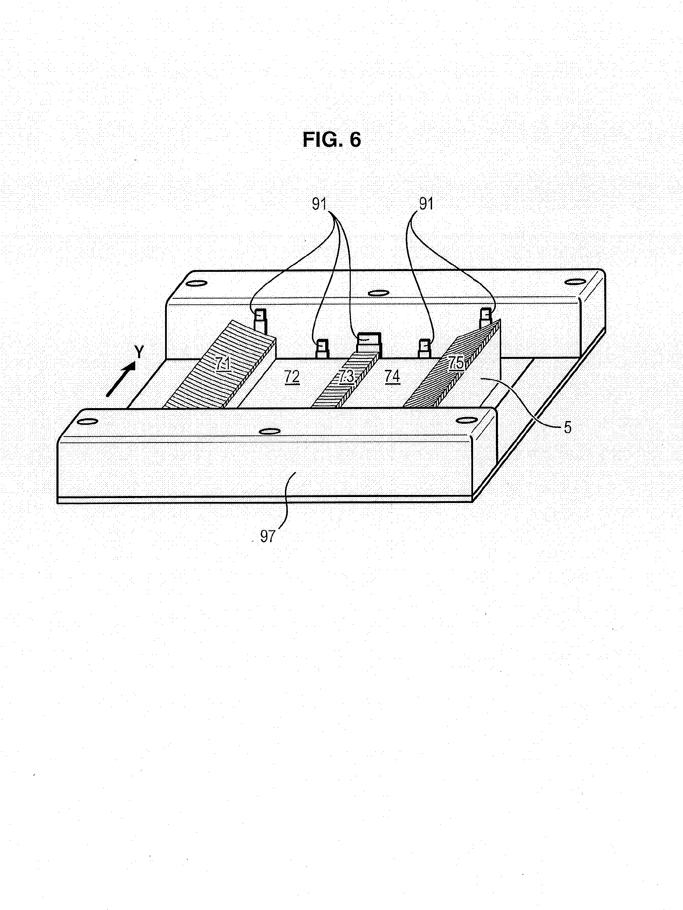

Figure 6 illustrates such a disposition of the detection means 9. This shows the pusher 5 in a detection position. Detection means 9 are arranged next to each of the zones 71, 72, 73, 74, 75 identified by their respective profiles, that is the external zones 71, 75, the intermediate zones 72, 74 and the central zone 73.

Figure 6 illustrates for example transmitters 91, receivers 92 (not visible under the hood 97) associated with each transmitter 91 being placed opposite transmitters 91 in the longitudinal direction Y of the pusher, under the hood 97 in the first plane. Therefore there is a transmitter 91/receiver 92 pair defining a detection region in the reception space 53 of the substrates for each of the zones 71, 72, 73, 74, 75 of the handling means 52.

The invention according to a second aspect relates to a control process of the device 1, in which, apart from the steps mentioned earlier, comprises a step according to which the pusher 5 is immobilised in its detection position until determination of the absence of obstacles inside the regions of the reception spaces 53 by the detection means 9.

Each time the pusher 5 reaches its detection position, it is preferably immobilised until determination of the absence of obstacles inside the regions of the reception spaces 53 by the detection means 9.

Furthermore, the determination of the presence of obstacles inside the regions of the reception spaces 53 by the detection means 9 causes the stoppage of the displacements of elements of the device 1.

Because of this, any debris, for example a piece of silicon, which might cut one or more beams 10, stops all movement of the splitting device 1, preventing any damage and alerting the user of the splitting device 1 of the necessity of cleaning the debris.

## Claims

1. A device (1) for splitting a substrate (2), said substrate comprising two adjoining wafers defining between them a cleavage plane, said device comprising
- a base (11),
- splitting means (12) of substrate wafers,
- means for performing controlled displacement of some substrate wafers (2) comprising at least one pusher (5) mobile relative to the base (11) of the device (1) comprising handling means (52) for substrates, said handling means (52) being adapted to accommodate substrates in a reception space (53) of the substrates (2) on the pusher (5),
said pusher (5) being capable of displacing substrates (2) arranged in a support (8), the direction of storage of said substrates defining a longitudinal direction (Y), the device being **characterised in that** it comprises detection means (9) adapted for determining the absence or the presence of obstacles inside at least one region of the reception space (53) of the pusher (5) when the pusher (5) is in a detection position, said region being located near the handling means (52) of substrates.

2. The device (1) according to Claim 1, in which the detection means (9) are solidary with the base (11).

3. The device (1) according to any one of Claims 1 to 2, in which the detection means (9) comprise at least one transmitter (91) for sending a beam (10) of electromagnetic waves and a receiver (92) associated with said transmitter (91) for receiving said beam (10) of electromagnetic waves, the trajectory of the beam (10) of electromagnetic waves between the transmitter (91) and the receiver (92) defining a region of the reception space (53) inside which the absence or the presence of obstacles is determined when the pusher (5) is in a detection position.

4. The device (1) according to the preceding claim, in which a transmitter (91) and a receiver (92) associated with said transmitter (91) are placed according to the longitudinal direction (Y).

5. The device according to any one of Claims 3 to 4, in which the reception space (53) of the substrates is located between the transmitter (91) and the receiver (92) when the pusher (5) is in a detection position.

6. The device (1) according to any one of Claims 1 to 5, in which the handling means (52) of the substrates present a section profile (6) in a section perpendicular to the longitudinal direction (Y) of the pusher (5) comprising several zones (7) **characterised by** a distinct profile zone in the section perpendicular to the longitudinal axis (Y), the detection means (9) being placed so as to define a region of the reception space (53) of substrates (2) associated with each of the zones (7), the absence or the presence of obstacles being determined for each of the regions of the reception space (53) of substrates (2) associated with each of the zones (7).

7. The device (1) according to any one of Claims 1 to 6, in which the detection position of the pusher (5) is located between a retracted position of the pusher (5) in the base (11) and a position in which the pusher (5) supports the substrates (2).

8. A control process of the device (1) according to Claim 7, in which the pusher (5) is immobilised in its detection position until determination by the detection means (9) of the absence of obstacles inside said regions of the reception space (53).

9. The control process of the device (1) according to Claim 8, in which each time the pusher (5) reaches its detection position, the latter is immobilised until determination by the detection means (9) of the absence of obstacles inside said regions of the reception space (53).

10. The control process of the device (1) according to one of Claims 8 and 9, in which determination of the presence of obstacles inside said regions of the reception space (53) by the detection means (9) causes stoppage of displacements of elements of the device (1).
